# EUROPEAN PATENT APPLICATION

(11) **EP 4 770 408 A1**
(43) Date of publication of application: **01.07.2026**
(21) Application number: 25222130.4
(22) Date of filing: 10.12.2025
(51) Int. Cl.: H10W 40/70, H10W 70/68, H10W 70/685, H10W 70/692, H10W 40/20, H10W 40/25, H10W 40/77, H10W 70/09, H10W 70/60, H10W 74/10, H10W 90/10

(54) **PACKAGING SUBSTRATE AND MANUFACTURING METHOD THEREOF**

(30) Priority: 27.12.2024 US 202463739132 P
(71) Applicant: Absolics Inc., Covington, GA 30014 (US)
(72) Inventor: KIM, Younggeun, Covington, Georgia, 30014 (US); KIM, Tae Kyoung, Covington, Georgia, 30014 (US)
(74) Representative: BCKIP Part mbB

(57) **Abstract**

The embodiments relate to a packaging substrate and a manufacturing method thereof. The packaging substrate comprises: a glass core comprising plate-shaped glass and a cavity disposed in the plate-shaped glass; a first element module disposed in the cavity; an upper layer disposed over the glass core and comprising redistribution lines; and a lower layer disposed under the glass core and comprising redistribution lines. The upper layer comprises an electrically conductive layer disposed over a top surface of the glass core, and the lower layer further comprises a module bottom metal layer, which is a metal layer disposed on a bottom surface of the first element module. The module bottom metal layer covers at least 60% of an area of one surface of a first element disposed in the first element module, and the module bottom metal layer is exposed at a bottom surface of the lower layer.

## Description

This application claims priority of U.S. Provisional Patent Application No. 63/739,132, filed on December 27, 2024.

### BACKGROUND

### TECHNICAL FIELD

The embodiments relate to a packaging substrate, in which an element is disposed inside a glass core to improve thermal stability, and to a manufacturing method thereof.

### DESCRIPTION OF RELATED ART

In manufacturing processes for electronic components, front-end (FE) processes may implement circuits on semiconductor wafers, and back-end (BE) processes may assemble wafers into states usable as actual products. A packaging process may be included in the BE processes.

As four core technologies of the semiconductor industry that have enabled the remarkable recent development of electronic products, semiconductor, semiconductor packaging, semiconductor manufacturing, and software technologies can be cited.

Semiconductor technology, in various areas such as sub-micro nano-scale line widths, more than ten million cells, high-speed operation, and heat dissipation, is constantly advancing. However, complete packaging technology may not be ensured. Accordingly, the electrical performance of a semiconductor may be determined not by the performance of the semiconductor technology itself but by packaging technology and the electrical interconnections associated therewith.

Related art includes, for example, Korean Patent No. 10-2216506 and Korean Patent Publication No. 10-2015-0024643.

### SUMMARY

This summary is provided to describe some concepts in a simplified form that are described in more detail in the following detailed description. It is not intended to identify essential features or to distinguish the claimed subject matter from the prior art, nor is it intended to be used to help determine the scope of the claimed rights.

In some embodiments, a packaging substrate in which an element is disposed inside a substrate and thermal stability is improved, and a manufacturing method thereof is provided.

In some embodiments, a packaging substrate having a cavity and a heat-dissipative metal layer, which reduces concern of parasitic element generation and allows a stable yet thin and space-efficient arrangement, and a manufacturing method thereof is provided.

According to the embodiments, a packaging substrate according to one embodiment includes: a glass core comprising plate-shaped glass and a cavity disposed in the plate-shaped glass; a first element module disposed in the cavity; an upper layer disposed over the glass core and comprising redistribution lines; and a lower layer disposed under the glass core and comprising redistribution lines.

The upper layer includes an electrically conductive layer disposed over a top surface of the glass core.

The lower layer further includes a module bottom metal layer, which is a metal layer disposed on a bottom surface of the first element module.

The module bottom metal layer may cover at least 60% of an area of one surface of a first element disposed in the first element module.

The module bottom metal layer may be exposed at a bottom surface of the lower layer.

The module bottom metal layer may have one end in contact with the first element and the other end exposed at a surface of the lower layer.

A dispensing layer may be disposed between a side of the first element module and a sidewall of the cavity.

The dispensing layer may comprise an insulating organic material or an organic-inorganic composite material.

A second element module may further be contained in the cavity.

At least one power-delivery element may be disposed in the second element module.

A redistribution layer may be disposed on a top surface or a bottom surface of the second element module.

A second element module may further be disposed in the cavity.

Two or more power-delivery elements may be disposed in the second element module.

The power-delivery elements may be molded with an insulating material.

The second element module may further include a through electrode disposed in molding over or under the power-delivery elements.

According to another embodiment, a method of manufacturing the packaging substrate includes: a preparation operation of disposing an adhesive layer on a bottom surface of a glass core in which a cavity and a core conductive layer are disposed; an element placement operation of disposing one or more element modules in the cavity; a dispensing operation of disposing a dispensing layer in the cavity; an upper-layer forming operation of disposing an upper layer over the glass core; and a lower-layer forming operation of removing the adhesive layer from the bottom surface of the glass core and disposing a lower layer under the glass core.

The cavity may be a through-type cavity.

The core conductive layer may be an electrically conductive pattern disposed on a surface of the glass core.

The upper layer may include redistribution lines disposed over a top surface of the glass core.

The lower layer may further include a module bottom metal layer, which is a metal layer disposed on a bottom surface of the first element module.

The module bottom metal layer may be a metal layer disposed on a bottom surface of the element module.

The module bottom metal layer may have one end that covers at least 60% of an area of one surface of a first element disposed in the element module and the other end that is exposed at a bottom surface of the lower layer.

In the lower-layer forming operation, the lower layer may be disposed with the glass core inverted top-to-bottom.

The lower-layer forming operation may include: disposing an insulating layer under the glass core after removal of the adhesive layer; selectively removing the insulating layer in a lower-insulating-layer cavity region where the module bottom metal layer is to be disposed; forming a seed layer in the lower-insulating-layer cavity region; and disposing copper paste or a copper block in the lower-insulating-layer cavity region.

The module bottom metal layer may have a thickness of 10 µm to 100 µm.

### BRIEF DESCRIPTION OF THE DRAWINGS

FIG. 1A is a conceptual cross-sectional view illustrating a state in which an element is mounted on the packaging substrate according to an embodiment.
FIG. 1B is a conceptual cross-sectional view illustrating a state before an element is mounted on the packaging substrate according to an embodiment.
FIGS. 2 to 8 are conceptual cross-sectional views each illustratively explaining, as examples, the sequence of operations of the manufacturing method of the packaging substrate according to an embodiment.

In the drawings as a whole and in the detailed description, the same reference numerals may designate the same or similar components. The drawings are not necessarily to scale for clarity, and the relative sizes, ratios, and depictions of components in the drawings may be exaggerated for clarity, schematization, and convenience.

### DESCRIPTION OF THE EMBODIMENTS

The following detailed description is provided to assist in comprehensively understanding the methods, devices, and/or systems described in the present specification. However, upon understanding the disclosure of the present application, it will be apparent that various changes, modifications, and equivalents to the methods, devices, and/or systems described herein may be made. For example, the sequence of operations described herein is merely illustrative and is not limited to the operations set forth; upon understanding the disclosure, it will be apparent that the sequence may be changed, with the exception of operations that are required to be performed in a particular order. In addition, descriptions of well-known features may be omitted to enhance clarity and conciseness after understanding the disclosure of the present application, and the omission or description of features does not constitute an acknowledgment as to whether such features are common knowledge.

The features described in this specification may be implemented in other forms, and should not be construed as being limited to the examples described in this specification. The terminology used in this specification is used to describe particular examples and is not intended to limit the present disclosure. The examples described herein are merely provided to illustrate some of the many possible ways of implementing the methods, devices, and/or systems described in this specification.

Terms such as "first," "second," and "third" may be used in this specification to describe various components, components, regions, layers, or sections, but such terms are used only to distinguish one component, part, region, layer, or section from another component, part, region, layer, or section and do not limit the nature, order, or number. A first member, part, region, layer, or section described below may also be referred to as a second member, part, region, layer, or section without departing from the teachings of the embodiments.

Throughout this specification, when an element such as a layer, region, or substrate is described as being "over," "connected to," or "coupled to" another element, this encompasses both cases where the element is directly "over," "connected to," or "coupled to" the other element and cases where one or more other elements are interposed therebetween. Conversely, when an element is described as being "directly over," "directly connected to," or "directly coupled to" another element, no other element is interposed therebetween. Similarly, expressions such as "between" and "directly between," and "indirectly introduced" and "directly introduced," are to be interpreted in the same manner as described above.

The terms used in the present specification are used solely for the purpose of describing particular examples and are not intended to limit the present disclosure. The singular forms "a," "an," and "the" as used herein may include the plural forms unless the context clearly indicates otherwise. The term "and/or" as used herein includes any and all combinations of one or more of the listed items. The terms "include," "comprise," and "have" as used herein specify the presence of stated features, numbers, operations, elements, components, and/or combinations thereof, but do not preclude the presence or addition of one or more other features, numbers, operations, elements, components, and/or combinations thereof. In relation to embodiments (for example, with respect to what an example or embodiment may include or implement), the term "may" as used in this specification means that at least one example or embodiment exists in which such a feature is included or implemented, while not limiting all examples thereto.

Throughout this specification, "B is disposed on A" may mean that B is disposed in direct contact with A or that B is disposed on A with another layer or structure interposed therebetween, and such expressions are to be interpreted in accordance with what those of ordinary skill in the art would generally understand, and this is to be consistent after understanding of this document.

Throughout this specification, "B being disposed on A" means that B is disposed in direct contact with A or is disposed on A with another layer or structure interposed therebetween, and is not to be interpreted as being limited to a case where B is disposed in direct contact with A. Unless otherwise defined, all terms used in this document, on the premise of understanding this document, have the same meanings as those commonly understood by a person of ordinary skill in the art to which this document pertains, and are to be interpreted consistently in light of this document.

Terms defined in commonly used dictionaries are to be interpreted as having meanings consistent with those in the related art and the context of the present disclosure, and, unless explicitly defined herein, are not to be interpreted in an idealized or excessively formal sense.

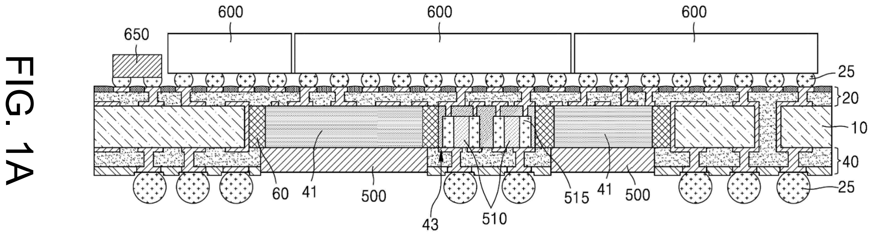

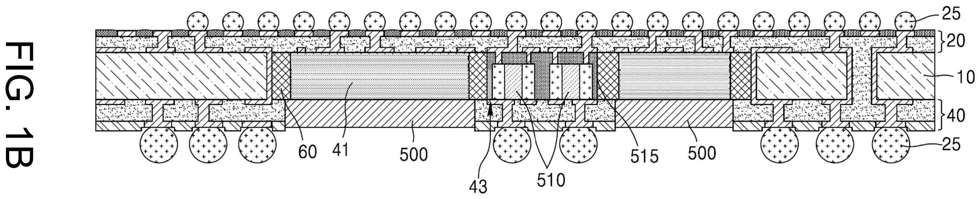

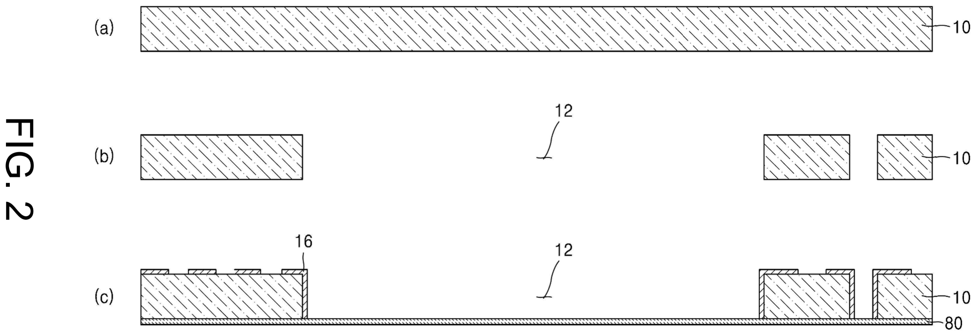

FIG. 1A is a conceptual cross-sectional view illustrating a state in which an element is mounted on the packaging substrate according to an embodiment, and FIG. 1B is a conceptual cross-sectional view illustrating a state before an element is mounted on the packaging substrate according to an embodiment. FIGS. 2 to 8 are conceptual cross-sectional views each illustratively explaining, by way of example, the sequence of operations of the manufacturing method of the packaging substrate according to an embodiment. The embodiments will be described in more detail with reference to the drawings.

To achieve the above object, a packaging substrate 900 according to one embodiment of the embodiments comprises a glass core 10 including plate-shaped glass and a cavity 12 disposed in the plate-shaped glass; a first element module 41 disposed in the cavity 12; an upper layer 20 disposed over the glass core 10 and including redistribution lines; and a lower layer 40 disposed under the glass core 10 and including redistribution lines.

It is preferable that the glass core 10 applies plate-shaped glass used for semiconductors, and, for example, borosilicate plate-shaped glass and alkali-free plate-shaped glass may be applied; however, the embodiments are not limited thereto.

The glass core 10 may be provided with a through-type core via 14 that penetrates the plate-shaped glass in a thickness direction and/or a cavity that penetrates the plate-shaped glass in a thickness direction. The core via 14 may be provided so as to electrically connect an upper portion and a lower portion of the glass core by forming a through electrode, so that transmission of electrical signals in an up-and-down direction of the glass core may be possible.

The glass core 100 may be 300 µm or greater. The thickness of the glass core 100 may be 300 µm or greater, 350 µm or greater, 400 µm or greater, 450 µm or greater, or 500 µm or greater. The thickness may be 2000 µm or less, 1800 µm or less, 1500 µm or less, 1200 µm or less, 1000 µm or less, 800 µm or less, or 700 µm or less. When a glass core of such thickness is applied, durability at a certain level or higher may be ensured, and the glass core may serve as a support.

The cavity 12 may be provided in a form in which a part of the glass core 100 is removed. In an embodiment, the cavity 12 may be applied as a full cavity in which the glass core is penetrated.

A semiconductor element (hereinafter, "element") may be disposed in the cavity 12. Such an element is referred to as a "cavity element" to distinguish it from an element mounted on the packaging substrate.

The cavity element may be applied as an element module. One or two or more individual semiconductor elements may be disposed in the element module. Thirty or fewer, or twenty or fewer, individual semiconductor elements may be disposed in the element module. By applying the cavity element in a modularized form, the pick-and-space process may be made more efficient, and the accuracy of spacing or positioning between the elements may be further improved.

The element module may be such that side surfaces of the cavity element are wrapped with an insulator. When cavity elements are arranged in rows within the element module, in some cases a cavity element may be disposed deviating from a predetermined position, which may induce contact between the cavity elements and lead to a defect of the packaging substrate. The element module of the embodiments may suppress occurrence of defects due to contact between elements through an insulator disposed on side surfaces of the cavity element.

The cavity element may be an active element or a passive element.

As a passive element, by way of example, a power-delivery element such as an MLCC (Multi-Layer Ceramic Capacitor) may be applied, but is not limited thereto.

As an active element, by way of example, a transistor may be applied, but is not limited thereto.

The form of the element module or the cavity element may differ between a case where a passive element is disposed as the cavity element and a case where an active element is disposed.

As an example, a case in which an active element is disposed in the first element module 41 will be described.

In the first element module 41, one or more elements are disposed, and side surfaces of the element may be covered with a protective layer 415. The protective layer 415 may be formed of an insulating material. The insulating material may comprise a polymer resin or a mixture of inorganic particles and a polymer resin. The insulating material may comprise, by way of example, LCP (liquid crystal polymer), EMC (Epoxy Molding Compound), ABF (Ajinomoto Build-up Film), or MPI (Modified Polyimide).

In the first element module 41, a cavity distribution layer 413 may be disposed on one surface of the active element. The cavity distribution layer 413 connects the first element module 41 to redistribution lines within the packaging substrate to enable transmission of signals of the active element in the first element module 41. The cavity distribution layer 413 may be formed on the active element, for example, by a method of manufacturing redistribution lines.

The first element module 41 may comprise the first element 410 which is an active element, the protective layer 415 which is an insulating material on side surfaces, and the cavity distribution layer 413 on one surface of the active element. In this case, for process convenience, it is preferable that the first element module 41 be inserted into the cavity 12 in a state prepared in advance so that the configuration described above is provided.

An upper layer 20 comprising redistribution lines may be disposed over the glass core 10.

The upper layer 20 comprises an electrically conductive layer disposed over a top surface of the glass core 10.

An electrically conductive layer disposed over a top surface of the glass core 10 may be provided in a predetermined pattern. For example, after performing a primer treatment such as sputtering on a surface of the glass core (optionally including an interior of the core via 14 or an inner wall of the cavity), copper plating may be performed and unnecessary portions may be removed, but the embodiments are not limited thereto.

The upper layer 20 may be formed by a method for manufacturing redistribution lines applied to manufacturing of the packaging substrate. For example, the upper layer 20 may be provided by repeating formation of a primer layer on the top surface of the glass core 10, disposition of an insulating layer on the primer layer, selective removal of the insulating layer, plating of a copper layer, and planarization.

A cover layer 28 may be further disposed over the upper layer 20.

The cover layer 28 may be, for example, a PI (polyimide) film having openings at portions where solder balls are bonded, but is not limited thereto.

Under the glass core 10, a lower layer 40 comprising redistribution lines may be disposed. The lower layer 40 may be connected to an electrically conductive layer disposed on a bottom surface of the glass core 10.

An electrically conductive layer disposed on the bottom surface of the glass core 10 may be provided in a predetermined pattern. For example, after performing a primer treatment such as sputtering on a surface of the glass core (optionally including an interior of the core via 14 or an inner wall of the cavity), copper plating may be performed and unnecessary portions may be removed, but the embodiments are not limited thereto.

A solder resist layer 417 may be further disposed under the lower layer 40.

The lower layer 40 may be formed by a method for manufacturing redistribution lines applied to manufacturing of the packaging substrate. For example, the lower layer 40 may be provided by repeating formation of a primer layer on the bottom surface of the glass core 10, disposition of an insulating layer on the primer layer, selective removal of the insulating layer, plating of a copper layer, and planarization.

The lower layer 40 may further comprise a module bottom metal layer 500, which is a metal layer disposed on a bottom surface of the first element module 41.

The module bottom metal layer 500 is a metal layer that is connected to one surface of the first element module 41 and is disposed so as to pass through the lower layer 40.

The module bottom metal layer 500 may cover at least 60% of an area of one surface of the first element 410 disposed in the first element module 41. For example, the module bottom metal layer 500 may cover 60% or more, or 65% or more, 70% or more, 75% or more, 80% or more, 85% or more, 90% or more, 95% or more, 100% or more, or 105% or more of an area of one surface of the first element 410 disposed in the first element module 41. Further, it may cover an area of 130% or less, 120% or less, or 110% or less of the area of the one surface. In this case, an area greater than 100% means that the module bottom metal layer 500 protrudes laterally beyond the said bottom surface.

The module bottom metal layer 500 may be exposed at a bottom surface of the lower layer 40.

Specifically, the module bottom metal layer 500 may have one end in contact with the first element 410 and the other end exposed at a bottom-surface side of the lower layer 40.

The module bottom metal layer 500 may have a thickness of 10 µm to 100 µm. The thickness may be 10 µm or greater, 15 µm or greater, 20 µm or greater, 25 µm or greater, 30 µm or greater, 35 µm or greater, 40 µm or greater, 45 µm or greater, 50 µm or greater, 55 µm or greater, or 60 µm or greater. Further, the thickness may be 100 µm or less, 95 µm or less, 90 µm or less, 85 µm or less, or 80 µm or less. When the module bottom metal layer 500 is formed with such a thickness, both heat-dissipation effect and process efficiency may be improved.

The module bottom metal layer 500 may guide heat generated from the element to be efficiently discharged to outside of the packaging substrate 900.

A manufacturing method of the module bottom metal layer 500 will be described later.

Two or more element modules may be disposed in the cavity 12.

The element module may be one in which an active element corresponding to the above-described first element module 41 is disposed. The element module may also be one in which a passive element is disposed, and, for the purpose of distinguishing it from the first element module 41 in which an active element is disposed, it is referred to as the second element module 43.

A second element module 43 may further be included in the cavity 12.

In the second element module 43, at least one second element 510 may be disposed. The second element 510 may comprise, by way of example, a power-delivery element such as an MLCC.

The number of power-delivery elements disposed in one second element module 43 may be two or more, ten or more, twenty or more, thirty or more, forty or more, or fifty or more. Further, the number may be six hundred or less, five hundred or less, four hundred or less, three hundred or less, two hundred or less, one hundred seventy or less, one hundred forty or less, one hundred twenty or less, or ninety or less.

One second element module 43 may be disposed in the cavity 12. Alternatively, two or more, three or more, four or more, or five or more may be disposed. The second element module 43 may be disposed in the cavity 12 in a number of fifteen or less, thirteen or less, or ten or less.

By applying the power-delivery elements in a modularized manner, second elements pre-positioned at accurate locations may be disposed in the cavity of the packaging substrate while improving the efficiency of pick-and-space, thereby simultaneously enhancing efficiency of power delivery and accuracy of the process.

A redistribution layer may be disposed on a top surface or a bottom surface of the second element module 43. The redistribution layer may be provided on an upper or lower portion of the second element module 43 by utilizing a usual method of forming a redistribution layer. When the second element module 43 thus includes a redistribution layer, after fixing the second element module 43 to the cavity 12, an upper layer or a lower layer may be formed to facilitate electrical connection between the second element 510 and the upper layer or the lower layer.

The second element module 43 may further comprise a through electrode disposed in molding over or under the power-delivery element. The through electrode may be one that is formed in advance during a manufacturing process of the second element module. Alternatively, after disposing the second element module in the cavity, a blind via may be formed and an electrode may be disposed by a method such as copper plating to provide a through electrode. In the former case, it is advantageous in that efficiency of manufacturing the packaging substrate may be further improved.

One or more first element modules 41 or one or more second element modules 43 may be disposed in the cavity 12.

One or more first element modules 41 and one or more second element modules 43 may be disposed in the cavity 12.

When the cavity 12 is provided inside the glass core 10 and element modules are disposed therein, the space within the packaging substrate can be utilized efficiently while simultaneously improving the efficiency of power delivery.

After the element module is disposed in the space of the cavity 12, a space is created between the element module and a wall surface of the cavity. In addition, when a plurality of element modules are applied, spaces are also generated between the element modules disposed in the cavity. A dispensing layer 60 is disposed in such spaces.

The dispensing layer 60 may be provided by disposing a dispense material 410 (Dispense Material) in the space. The dispense material fills a space between the cavity inner wall and the element modules and fixes their relative positions.

As the dispense material, an insulating material may be applied by way of example.

As the insulating material, an organic material or an organic-inorganic composite material may be applied.

The insulating material may be a polymer resin, a mixed material of a polymer resin and a filler (inorganic particles, organic particles, organic-inorganic composite particles, etc.), or an inorganic deposition layer.

The polymer resin may comprise an acrylic resin, an epoxy resin, and modified resins thereof, and a material applicable to electronic devices for purposes such as molding may be applied. By way of example, an LCP (liquid crystal polymer) may be applied.

The mixed material may comprise a mixture of an acrylic resin and a filler, a mixture of an acrylic resin and an epoxy resin together with a filler, or a mixture of an epoxy resin and a filler. As the filler, inorganic particles may be applied, and, by way of example, silica particles may be applied.

As commercial products for the dispense material, ABF (Ajinomoto Build-up Film), EMC (Epoxy Molding Compound), MPI (Modified Polyimide), CUF (Capillary Underfill) materials, NCF (Non-Conductive Films), and NCP (Non-Conductive Pastes) may be applied.

The dispense material may be transformed into a form having fluidity, be disposed inside the glass core while filling the space between the cavity inner wall and the element module, and then be cured. For example, the dispense material is fluidized by temperature elevation, is disposed at an appropriate position, and then, by a method such as thermal curing, may fix the position of the element module within the cavity inner wall.

The packaging substrate 900 may have a structure of the upper layer 20 and the glass core 10.

The packaging substrate 900 may have a structure of the upper layer 20, the glass core 10, and the lower layer 40.

The structure in which element modules are disposed inside the cavity 12 disposed in the glass core 10 is as described above.

In openings of a protective layer of the upper layer 20, a connection portion such as a bump layer 25 may be disposed. The bump layer 25 on the upper layer 20 may be connected to a mounting element 600 described later. If necessary, the bump layer 25 on the upper layer 20 may be connected to a cap 650.

A separate bump layer 25 may further be provided under a bottom surface of the glass core 10 or under a solder resist layer 417 of the lower layer 40. The bump layer 25 under the solder resist layer 417 may be connected to the outside of a packaged semiconductor device, such as a main board.

A semiconductor element may be mounted on the packaging substrate 900. For the purpose of distinguishing it from other elements such as cavity elements, it is referred to as a "mounting element" 600.

The mounting element 600 may be applied in a modularized form. The modularized mounting element 600 includes one or more elements 610.

By way of example, the mounting element 600 may include various elements such as a computing element like a CPU or GPU, and a memory element such as a memory chip.

The mounting element 600 may be applied in a module form.

In the module form, the mounting element 600 may, by way of example, have one or two or more elements disposed, and its side surfaces may be protected by a molding material similar to the protective layer mentioned above, or it may be molded as a whole. In addition, a redistribution layer may be separately disposed on a bottom surface of the mounting element 600. This redistribution layer may make electrical connections within the mounting element 600 efficient or improve efficiency of electrical connection between the packaging substrate 900 and the mounting element 600.

FIGS. 2 to 8 are conceptual cross-sectional views each illustratively explaining, by way of example, the sequence of operations of the manufacturing method of the packaging substrate according to an embodiment. The manufacturing method of the packaging substrate 900 will be described with reference to FIGS. 2 to 8.

The manufacturing method of the packaging substrate 900 according to an embodiment manufactures the packaging substrate 900 described above.

The manufacturing method comprises: a preparation operation; an element placement operation; a dispensing operation; an upper-layer forming operation; and a lower-layer forming operation.

The preparation operation is an operation of disposing an adhesive layer 80 on a bottom surface of the glass core 10 in which the cavity 12 and the core conductive layer 16 are disposed (see (a) to (c) of FIG. 2).

The cavity 12 may be a through-type cavity 12.

The core conductive layer 16 is an electrically conductive pattern disposed on a surface of the glass core 10. Before the adhesive layer 80 is disposed, the core conductive layer 16 may be disposed on the glass core 10.

As the adhesive layer 80, an adhesive layer applied to semiconductor processes may be applied, and, by way of example, a silicone adhesive layer or an acrylic adhesive layer may be applied.

By way of example, the adhesive layer 80 may be one whose adhesive force changes by ultraviolet irradiation. Specifically, the adhesive layer applied to fix positions is to be removed later. That is, after attachment, the adhesive force is maintained; when removal is required, before removing the adhesive layer, the adhesive force may be weakened by a method such as ultraviolet irradiation so that it may be removed relatively easily.

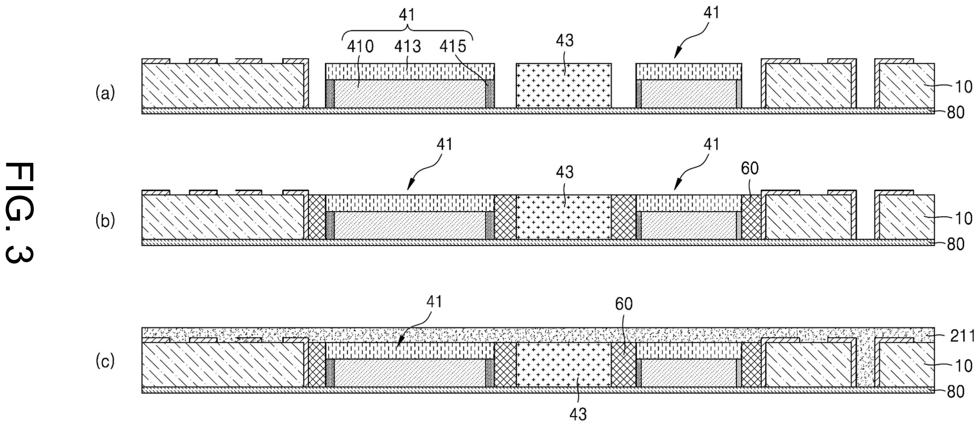

The element placement operation is an operation of disposing one or more element modules 41 in the cavity 12 (see (a) of FIG. 3).

In the cavity 12, one or two or more individual elements may be disposed.

In the cavity 12, one or two or more modularized elements may be disposed.

Descriptions regarding elements and element modules overlap with the descriptions above, and detailed description is therefore omitted.

The dispensing operation is an operation of disposing a dispensing layer 60 inside the cavity 12.

Since the material and disposition of the dispensing layer 60 overlap with the descriptions above, detailed description is omitted.

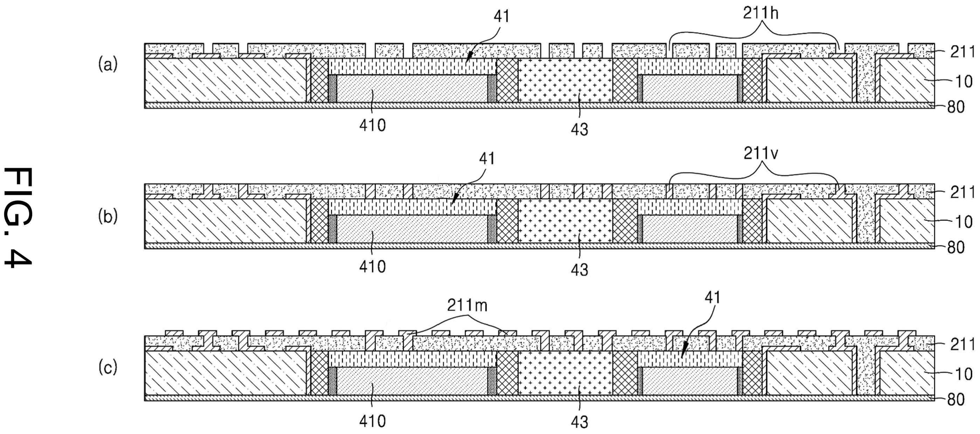

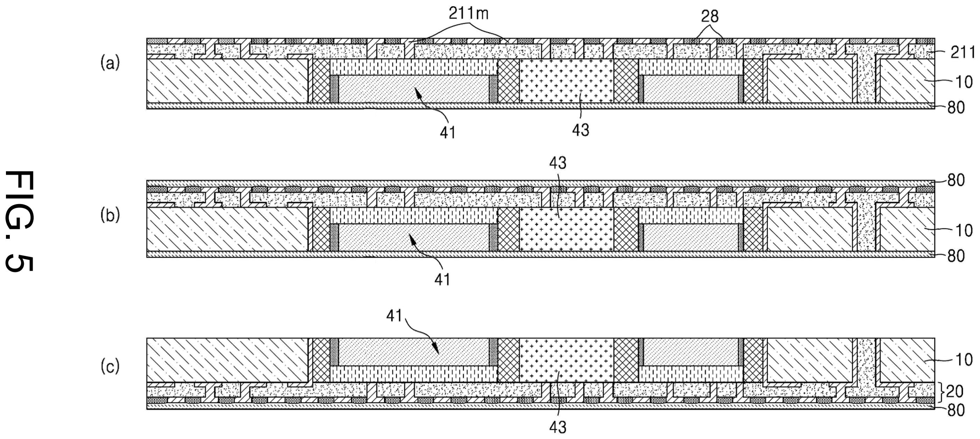

The upper-layer forming operation is an operation of disposing an upper layer 20 over the glass core 10 (see (c) of FIG. 3, (a) to (c) of FIGS. 4, and (a) of FIG. 5).

The upper layer 20 may comprise redistribution lines disposed over a top surface of the glass core 10.

An insulating layer is disposed over the glass core on which the dispensing layer has been disposed. This insulating layer is referred to as an upper insulating layer 211 (see (c) of FIG. 3). This insulating layer may be formed, by way of example, by pressure-reduced lamination of ABF followed by curing or semi-curing. As needed, before forming the insulating layer 211, a primer layer (for example, a sputtered layer that assists copper attachment) for forming a via electrode may be formed.

In the upper insulating layer 211, vias 211h and the like are formed (see (a) of FIG. 4). The positions where these vias or patterns of an electrically conductive layer are to be disposed may be formed by a method such as plasma etching or laser etching.

A via electrode 211v and/or an electrically conductive pattern is formed thereon. The via electrode 211v may comprise copper, a copper alloy, and the like, and may be formed, by way of example, by a method such as copper plating (see (b) and (c) of FIG. 4).

Although not illustrated, after copper plating, a planarization operation and the like may be performed, and by repeating the processes of forming the insulating layer 211 and disposing the vias 211h and/or the conductive pattern, an upper electrically conductive layer 211m is provided.

On an uppermost surface of the upper electrically conductive layer 211m, a cover layer 28 is disposed, and openings of the cover layer 28 may be disposed at positions where the cover layer 28 is to contact a bump layer (see (a) of FIG. 5).

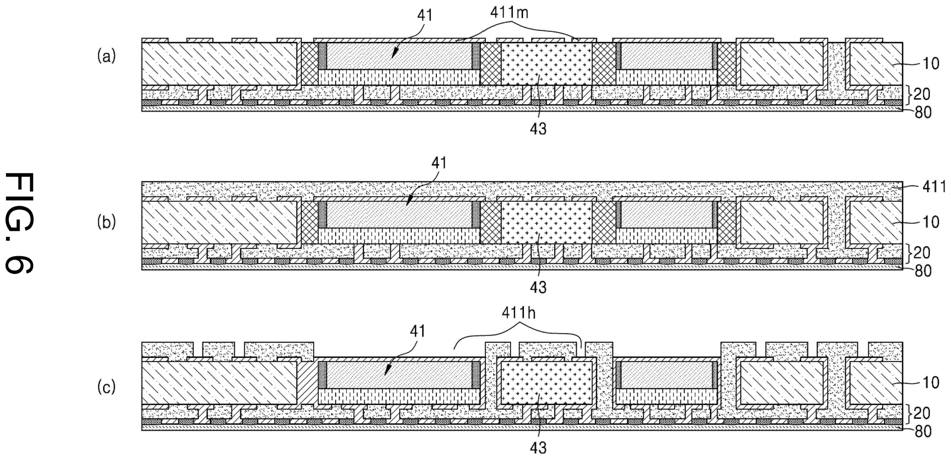

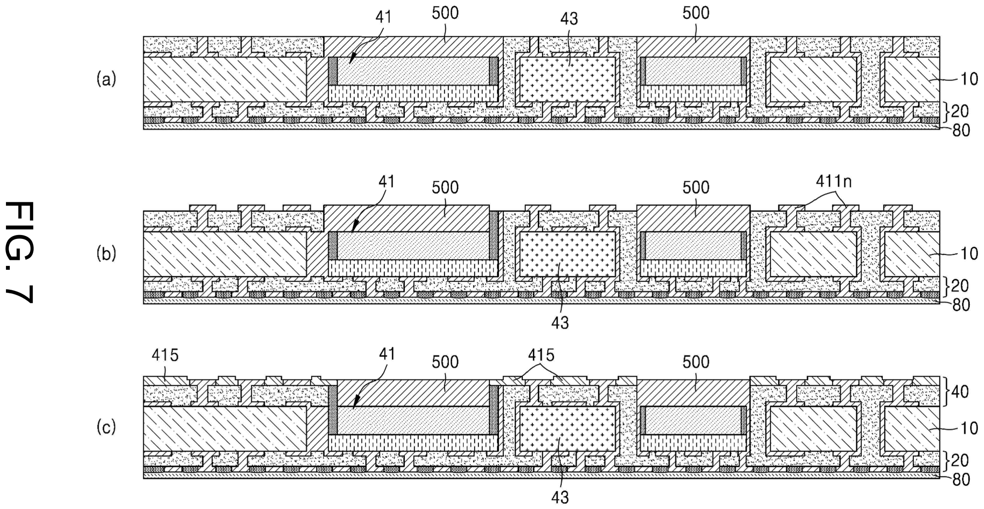

The lower-layer forming operation is an operation of removing the adhesive layer 80 from the bottom surface of the glass core 10 and disposing a lower layer 40 under the glass core 10 (see (b) and (c) of FIG. 5, (a) and (c) of FIG. 6, and (a) and (c) of FIG. 7).

An additional adhesive layer 80 is disposed over an upper portion of the upper layer 20. In addition, the adhesive layer 80 adhered to the bottom surface of the glass core 10 is peeled off. During such processes, the substrate is inverted top-to-bottom (see (b) and (c) of FIG. 5). Thereafter, a lower layer is formed.

An electrically conductive layer is disposed on a bottom surface of the glass core 10. This is referred to as a lower core electrically conductive layer 411m. This proceeds similarly to the disposition of an electrically conductive layer on a top surface of the glass core 10 (see (a) of FIG. 6).

An insulating layer is disposed thereover, which is referred to as a lower insulating layer 411 (see (b) of FIG. 6). This proceeds similarly to the formation process of the upper insulating layer 211 described above.

In the upper insulating layer 211, locations where vias and an electrically conductive pattern are to be disposed are etched (see (c) of FIG. 6). At this time, a lower insulating-layer cavity 411h is formed at a position where the module bottom metal layer 500 described above is to be disposed. Here, the etching of locations where the vias and the electrically conductive pattern are to be disposed, and the formation of the lower insulating-layer cavity 411h, may be performed by a method such as plasma etching or laser etching.

The lower insulating-layer cavity 411h may be formed such that an element module including the cavity element is exposed. In addition, the lower insulating-layer cavity 411h may be formed such that at least 60% or more, or 65% or more, 70% or more, 75% or more, 80% or more, 85% or more, 90% or more, 95% or more, 100% or more, or 105% or more of an area of one surface of the cavity element is exposed. The lower insulating-layer cavity 411h may be formed such that 130% or less, 120% or less, or 110% or less of the area of the one surface is exposed. In this case, when an area greater than 100% is exposed, a portion of the dispensing layer or the protective layer beside the bottom surface of the cavity element is exposed.

A lower-layer electrically conductive layer 411n is disposed therein. The lower-layer electrically conductive layer may be formed in a manner similar to the upper-layer electrically conductive layer.

At this time, the module bottom metal layer 500, which is a metal layer disposed on a bottom surface of the first element module 41, may be formed together with the lower-layer electrically conductive layer 411n (see (a) of FIG. 7).

The module bottom metal layer 500 has a considerably large volume compared to the vias or the electrically conductive pattern. Due to this, a time for plating and the like may become inefficiently long. Accordingly, in the embodiments, in order to efficiently form the module bottom metal layer 500, a method may be applied in which copper paste or a copper block is disposed in the lower insulating-layer cavity 12 region.

Specifically, the lower-layer forming operation may comprise: a process of disposing an insulating layer under the glass core 10 from which the adhesive layer 80 has been removed; a process in which a region where the module bottom metal layer 500 is to be disposed is the lower insulating-layer cavity 12 region, and the insulating layer of the lower insulating-layer cavity 12 region is selectively removed; a process of forming a seed layer in the lower insulating-layer cavity 12 region; and a process of disposing copper paste or a copper block in the lower insulating-layer cavity 12 region. Through this, a module bottom metal layer of sufficient volume can be formed at a fast process speed.

Thereafter, additional necessary lower-layer electrically conductive layers 411n are disposed on the lower layer, and a solder resist layer 417 is disposed to form the lower layer 40 (see (b) and (c) of FIG. 7).

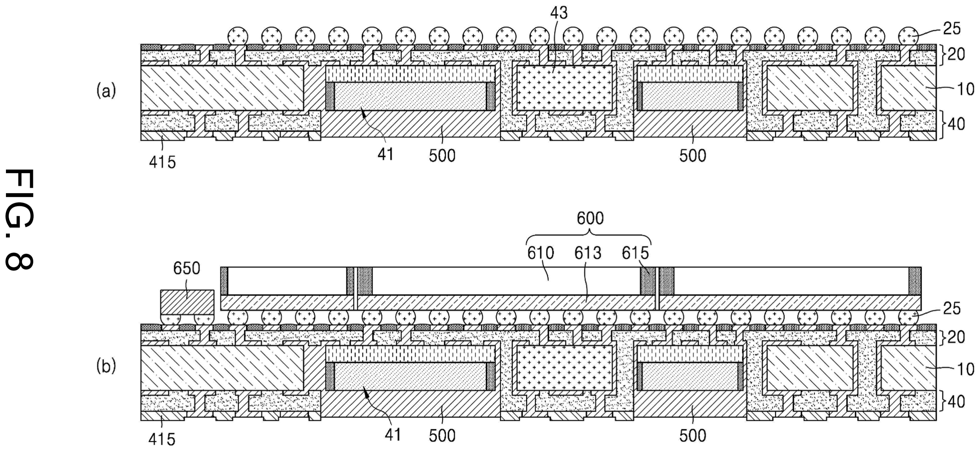

On the thus-manufactured packaging substrate 900, a bump layer 25 may optionally be formed over the upper layer 20 (see (a) of FIG. 8).

A mounting element 600 or a cap 650 may be disposed on the packaging substrate 900, and the cap 650 serves to block unnecessary through electrodes and prevent unnecessary electrical connections.

The packaging substrate and the manufacturing method thereof according to the embodiments can provide a packaging substrate in which an element is disposed inside a glass core while improving thermal stability, and can manufacture a packaging substrate having a cavity and a heat-dissipative metal layer that allows a stable yet thin and space-efficient arrangement with little concern about occurrence of parasitic elements.

The packaging substrate and the manufacturing method thereof according to the embodiments may provide a packaging substrate in which an element is disposed inside a substrate and thermal stability is improved.

The packaging substrate and the manufacturing method thereof according to the embodiments may provide a packaging substrate having a cavity and a heat-dissipative metal layer, with reduced concern of parasitic element generation and enabling a stable yet thin and space-efficient arrangement.

Although preferred embodiments of the present invention have been described in detail above, the scope of rights of the present invention is not limited thereto, and various modifications and improved forms by those skilled in the art using the basic concept of the present invention defined in the following claims also fall within the scope of rights of the present invention.

## Claims

1. A packaging substrate, comprising:
a glass core comprising plate-shaped glass and a cavity disposed in the plate-shaped glass;
a first element module disposed in the cavity;
an upper layer disposed over the glass core and comprising redistribution lines; and
a lower layer disposed under the glass core and comprising redistribution lines;
wherein the upper layer comprises an electrically conductive layer disposed over a top surface of the glass core,
wherein the lower layer further comprises a module bottom metal layer, which is a metal layer disposed on a bottom surface of the first element module,
wherein the module bottom metal layer covers at least 60% of an area of one surface of a first element disposed in the first element module, and
wherein the module bottom metal layer is exposed at a bottom surface of the lower layer.

2. The packaging substrate of claim 1,
wherein the module bottom metal layer has one end in contact with the first element and the other end exposed at a surface of the lower layer.

3. The packaging substrate of claim 1 or claim 2,
wherein a dispensing layer is disposed between a side of the first element module and a sidewall of the cavity, and
wherein the dispensing layer comprises an insulating organic material or an organic-inorganic composite material.

4. The packaging substrate of any one from claim 1 to claim 3,
wherein a second element module is further included in the cavity,
wherein at least one power-delivery element is disposed in the second element module, and
wherein a redistribution layer is disposed on a top surface or a bottom surface of the second element module.

5. The packaging substrate of any one from claim 1 to claim 4,
wherein a second element module is further disposed in the cavity,
wherein two or more power-delivery elements are disposed in the second element module, and
wherein the power-delivery elements are molded with an insulating material.

6. The packaging substrate of claim 5,
wherein the second element module further comprises a through electrode disposed in molding over or under the power-delivery elements.

7. A method of manufacturing a packaging substrate, comprising:
a preparation operation of disposing an adhesive layer on a bottom surface of a glass core in which a cavity and a core conductive layer are disposed;
an element placement operation of disposing one or more element modules in the cavity;
a dispensing operation of disposing a dispensing layer inside the cavity;
an upper-layer forming operation of disposing an upper layer over the glass core; and
a lower-layer forming operation of removing the adhesive layer from the bottom surface of the glass core and disposing a lower layer under the glass core;
wherein the cavity is a through-type cavity,
wherein the core conductive layer is an electrically conductive pattern disposed on a surface of the glass core,
wherein the upper layer comprises redistribution lines disposed over a top surface of the glass core,
wherein the lower layer further comprises a module bottom metal layer, which is a metal layer disposed on a bottom surface of the first element module,
wherein the module bottom metal layer is a metal layer disposed on a bottom surface of the element module, and
wherein the module bottom metal layer has one end that covers at least 60% of an area of one surface of a first element disposed in the element module and the other end that is exposed at a bottom surface of the lower layer.

8. The method of claim 7,
wherein, in the lower-layer forming operation, the lower layer is disposed with the glass core inverted top-to-bottom.

9. The method of claim 7 or claim 8,
wherein the lower-layer forming operation comprises:
disposing an insulating layer under the glass core after removal of the adhesive layer;
selectively removing the insulating layer in a lower-insulating-layer cavity region, which is a region where the module bottom metal layer is to be disposed;
forming a seed layer in the lower-insulating-layer cavity region; and
disposing copper paste or a copper block in the lower-insulating-layer cavity region.

10. The method of any one from claim 7 to claim 9,
wherein the module bottom metal layer has a thickness of 10 µm to 100 µm.
